# EUROPEAN PATENT APPLICATION

(11) **EP 4 220 726 A1**
(43) Date of publication of application: **02.08.2023**
(21) Application number: 20962945.0
(22) Date of filing: 27.11.2020
(51) Int. Cl.: H01L 27/32

(54) **DISPLAY SUBSTRATE, DISPLAY PANEL, AND DISPLAY APPARATUS**

(71) Applicant: BOE Technology Group Co., Ltd., Beijing 100015 (CN); Chengdu BOE Optoelectronics Technology Co., Ltd., Chengdu, Sichuan 611731 (CN)
(72) Inventor: DU, Lili, Beijing 100176 (CN); LONG, Yue, Beijing 100176 (CN)
(74) Representative: Cohausz & Florack
(86) International application number: PCT/CN2020/132413
(87) International publication number: WO 2022/110055

(57) **Abstract**

A display substrate, a display panel, and a display apparatus, the display substrate comprising: a base substrate (10) having a display area (AA) and a border area (BB) surrounding the display area (AA), the display area (AA) comprising: a first display area (AA1) and a second display area (AA2) positioned at least on one side of the first display area (AA1); the density of a plurality of first light emitting devices in the first display region (AA1) is the same as the density of a plurality of second light emitting devices in the second display region (AA2); and at least one transparent electrically-conductive layer positioned between a drive circuit layer and a light emitting device layer; each of the at least one transparent electrically-conductive layers comprises a plurality of first anode wires (101) electrically connected to first anodes (11); the first anode wires (101) at least comprise a first portion (01) extending in the column direction (Y) and a second portion (02) extending in the row direction (X), the second portion (02) of the plurality of first anode wires (101) electrically connected to the first anodes (11) in the same row being positioned between two different adjacent rows of first anodes (11), and the second portion (02) being led out along the row direction (X) to the outside of the first display region (AA1).

## Description

### Field

The present disclosure relates to the technical field of display, in particular to a display substrate, a display panel and a display apparatus.

### Background

With the rapid development of smart phones, it not only requires attractive appearances of phones, but also needs to give consideration to bring more excellent visual experience for phone users. Manufacturers begin to increase a screen-to-body ratio on smart phones, such that full-screen has become a novel competitive point of smart phones. With the development of full-screen, promoting requirements on the performance and functions are also increasing every day. Under-screen cameras, on the premise of not affecting a high screen-to-body ratio, can bring a sense of impact on the visual and use experience to a certain extent.

### Summary

In an aspect, embodiments of the present disclosure provide a display substrate, including:
a base substrate, having a display region and a frame region surrounding the display region, wherein the display region includes a first display region and a second display region at least located on one side of the first display region, and light transmittance of the first display region is greater than light transmittance of the second display region;
a drive circuit layer, located on the base substrate, and including a plurality of first pixel circuits and a plurality of second pixel circuits, wherein orthographic projections of the first pixel circuits on the base substrate do not overlap an orthographic projection of the first display region on the base substrate, and the second pixel circuits are located in the second display region;
a light-emitting device layer, located on one side of the drive circuit layer facing away from the base substrate, and including a plurality of first light-emitting devices and a plurality of second light-emitting devices, wherein the first light-emitting devices are located in the first display region, the second light-emitting devices are located in the second display region, each first light-emitting device includes a first anode independently arranged, and each second light-emitting device includes a second anode independently arranged; each of the plurality of first anodes is correspondingly and electrically connected with each of the plurality of first pixel circuits respectively, and each of the plurality of second anodes is correspondingly and electrically connected with each of the plurality of second pixel circuits respectively, wherein a density of the plurality of first light-emitting devices in the first display region is the same as a density of the plurality of second light-emitting devices in the second display region; and
at least one transparent conducting layer, located between the drive circuit layer and the light-emitting device layer, wherein each layer of the at least one transparent conducting layer includes a plurality of first anode wires electrically connected with the first anodes; and the first anode wires at least include a first portion extending in a column direction and a second portion extending in a row direction, the second portions of the first anode wires electrically connected with the same row of first anodes are located between different pairs of two adjacent rows of first anodes, and the second portions are led out in the row direction to an outside of the first display region.

Optionally, in the above display substrate provided by the embodiments of the present disclosure, the at least one transparent conducting layer includes a first transparent conducting layer and a second transparent conducting layer which are stacked and insulated from each other.

In every two adjacent rows of first anodes, the first anode wires corresponding to a row of first anodes are located on the first transparent conducting layer, and the first anode wires corresponding to the other row of first anodes are located on the second transparent conducting layer.

Optionally, in the above display substrate provided by the embodiments of the present disclosure, the first transparent conducting layer and the second transparent conducting layer have the same patterns.

Optionally, in the above display substrate provided by the embodiments of the present disclosure, the quantity of the first anode wires between two adjacent rows of first anodes corresponding to each transparent conducting layer is not greater than a first quantity, the quantity of the first anode wires between two adjacent columns of first anodes corresponding to each transparent conducting layer is not greater than a second quantity, and the first quantity is greater than the second quantity.

Optionally, in the above display substrate provided by the embodiments of the present disclosure, at least one row of first anodes is divided into a first region, a second region and a third region which are adjacent. The first anode wires corresponding to the first region are located between the same pair of two adjacent rows of first anodes, the first anode wires corresponding to the second region are located between the same pair of two adjacent rows of first anodes, the first anode wires corresponding to the third region are located between the same pair of two adjacent rows of first anodes, and the first anode wires corresponding to the first region, the second region and the third region are located between different pairs of two adjacent rows of first anodes.

Optionally, in the above display substrate provided by the embodiments of the present disclosure, the first region is close to the second display region, the second region is located on one side of the first region away from the second display region, and the third region is located on one side of the second region away from the second display region.

The quantity of the first anode wires corresponding to the first region is not greater than half of the first quantity, and the quantities of the first anode wires corresponding to the second region and the third region are both the first quantity.

Optionally, in the above display substrate provided by the embodiments of the present disclosure, at least one row of first anodes is divided into a fourth region, a fifth region and a sixth region which are adjacent. The first anode wires corresponding to the fourth region are located between the same pair of two adjacent rows of first anodes, the first anode wires corresponding to the fifth region are located between the same pair of two adjacent rows of first anodes, the first anode wires corresponding to the sixth region are located between different pairs of two adjacent rows of first anodes, and the first anode wires corresponding to the fourth region, the fifth region and the sixth region are located between different pairs of two adjacent rows of first anodes.

Optionally, in the above display substrate provided by the embodiments of the present disclosure, the fourth region is close to the second display region, the fifth region is located on one side of the fourth region away from the second display region, and the sixth region is located on one side of the fifth region away from the second display region.

The quantity of the first anode wires corresponding to the fourth region is the first quantity, the quantity of the first anode wires corresponding to the fifth region is the first quantity, and the quantity of the first anode wires corresponding to the sixth region is not greater than half of the first quantity.

Optionally, in the above display substrate provided by the embodiments of the present disclosure, the first quantity is 11-15, and the second quantity is 2-6.

Optionally, in the above display substrate provided by the embodiments of the present disclosure, the plurality of first anode wires contained in each transparent conducting layer do not overlap one another, and orthographic projections of the plurality of first anode wires contained in different transparent conducting layers on the base substrate are staggered with each other.

Optionally, in the above display substrate provided by the embodiments of the present disclosure, the first anodes and the transparent conducting layers have an insulation layer therebetween. The insulation layer has a plurality of via holes for electrically connecting the first anodes with the first anode wires. Orthographic projections of the first anode wires on the base substrate do not overlap orthographic projections of the via holes on the base substrate.

Optionally, in the above display substrate provided by the embodiments of the present disclosure, the plurality of first pixel circuits are located in the frame region adjacent to the first display region.

Optionally, in the above display substrate provided by the embodiments of the present disclosure, the second display region has a seventh region and an eighth region which are adjacent to the first display region. The seventh region and the eighth region are oppositely arranged. An area occupied by a second pixel circuit in the seventh region or the eighth region is smaller than an area occupied by a second pixel circuit in other regions of the second display region. The plurality of first pixel circuits are located in the seventh region and the eighth region.

Optionally, in the above display substrate provided by the embodiments of the present disclosure, a shape of the first display region is a circle, an oval, a rectangle or a polygon.

Optionally, in the above display substrate provided by the embodiments of the present disclosure, the first display region is divided into four equal parts along center lines of the row direction and the column direction, and the first anode wires of each equal part all adopt a layout mode of the first anode wires in the display substrate according to any one of claims 1-13.

Optionally, in the above display substrate provided by the embodiments of the present disclosure, the four equal parts include a first equal part, a second equal part, a third equal part and a fourth equal part which are clockwise arranged. The first equal part and the second equal part are symmetrically arranged with respect to the center line of the column direction, the second equal part and the third equal part are symmetrically arranged with respect to the center line of the row direction, the third equal part and the fourth equal part are symmetrically arranged with respect to the center line of the column direction, and the fourth equal part and the first equal part are symmetrically arranged with respect to the center line of the row direction.

Optionally, in the above display substrate provided by the embodiments of the present disclosure, the one row of first anodes closest to the fourth equal part in the first equal part is a first row of first anodes, the one row of first anodes closest to the first equal part in the fourth equal part is a second row of first anodes, a first gap is located between the first row of first anodes and the second row of first anodes, and the first anode wires corresponding to the first region close to the second display region in the first row of first anodes and the first anode wires corresponding to the first region close to the second display region in the second row of first anodes are located in the first gap.

In another aspect, embodiments of the present disclosure further provide a display panel, including the above display substrate.

In yet another aspect, embodiments of the present disclosure further provide a display apparatus, including: a photosensitive device, and the above display panel; and the photosensitive device is arranged in a first display region of the display substrate.

### Brief Description of the Drawings

Fig. 1 is a schematic top view of a display substrate in the related art.
Fig. 2 is a schematic structural diagram of a display substrate provided by an embodiment of the present disclosure.
Fig. 3 is an enlarged schematic diagram of a first display region in Fig. 2.
Fig. 4 is an enlarged schematic diagram of wires in the first display region in Fig. 2.
Fig. 5 is an enlarged schematic diagram of an upper left part in Fig. 4.
Fig. 6 is a schematic structural diagram of another display substrate provided by an embodiment of the present disclosure.
Fig. 7 is a schematic top view of a transparent conducting layer provided by an embodiment of the present disclosure.
Fig. 8 is a schematic sectional view of a transparent conducting layer provided by an embodiment of the present disclosure.
Fig. 9 is a schematic diagram of layout of the wires in the first display region in Fig. 2.

### Detailed Description of the Embodiments

In order to make objectives, technical solutions and advantages of embodiments of the present disclosure clearer, the technical solutions of the embodiments of the present disclosure will be clearly and completely described below with reference to accompanying drawings of the embodiments of the present disclosure. Apparently, the described embodiments are some, but not all, embodiments of the present disclosure. The embodiments in the present disclosure and features in the embodiments can be combined with each other in the case of not conflicting. Based on the described embodiments of the present disclosure, all other embodiments obtained by those of ordinary skill in the art without creative work shall fall within the protection scope of the present disclosure.

Unless otherwise defined, technical or scientific terms used herein should have the ordinary meaning as understood by those of ordinary skill in the art to which the present disclosure pertains. "Comprise" or "include" and similar words used in the present disclosure mean that the elements or objects appearing before the words cover the elements or objects recited after the words and their equivalents, but do not exclude other elements or objects. The words "connect" or "link" or the like are not limited to physical or mechanical connection, but may include electrical connection, whether direct or indirect. "Inner", "outer", "up", "down" and the like are merely used to represent a relative position relationship, and after an absolute position of a described object is changed, the relative position relationship may also be changed accordingly.

It needs to be noted that sizes and shapes of all figures in accompanying drawings do not reflect true scales, and are only intended to schematically illustrate the content of the present disclosure. The same or similar reference numerals represent the same or similar elements or elements with the same or similar functions throughout.

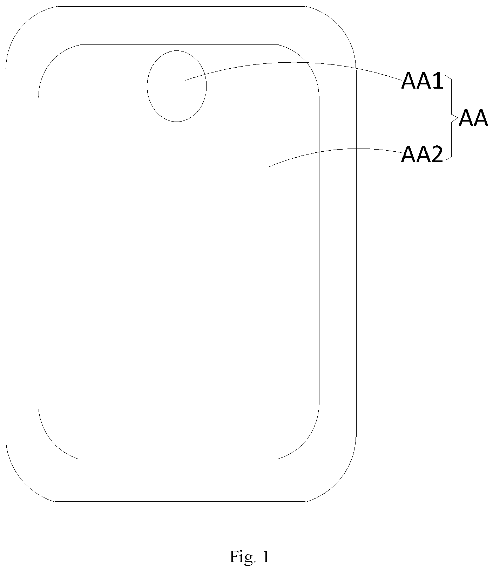

In the related art, as shown in Fig. 1, with an under-screen camera technology, a first display region AA1 and a second display region AA2 are generally provided in a display region AA. The second display region AA2 occupies most part of a display screen, and the first display region AA1 occupies the rest part of the display screen. The first display region AA1 is a position where an under-screen camera is placed. The under-screen camera is a front-facing camera, located below the screen and not affecting a screen display function. When the front-facing camera is not used, the screen above the camera may still normally display an image. Looking from the appearance, the under-screen camera may have no camera hole, and a full-screen display effect is really achieved. However, at present, in an OLED display apparatus designed with an under-screen camera, display brightness of the first display region AA1 is at least twice lower than display brightness of the second display region AA2, which is an urgent problem to be solved.

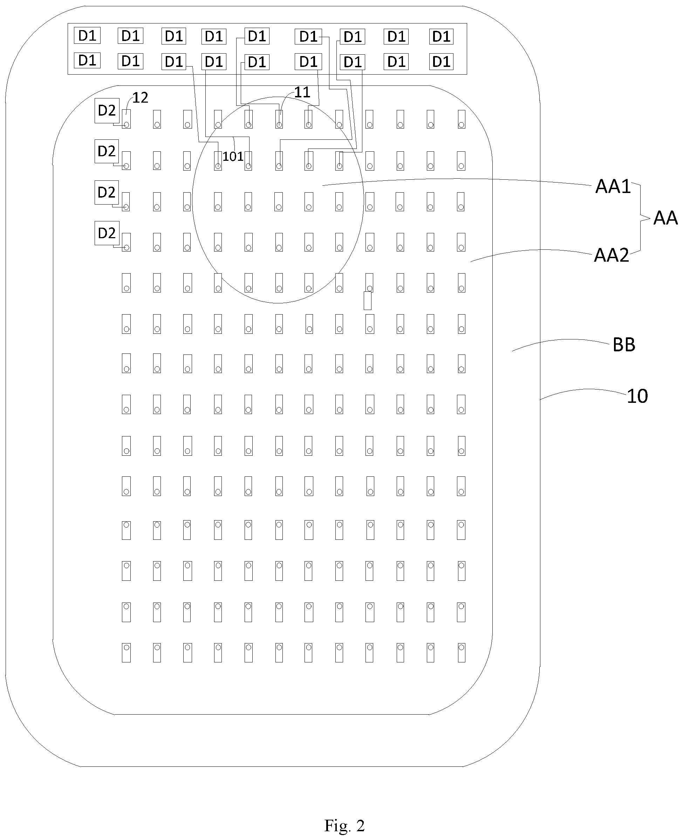

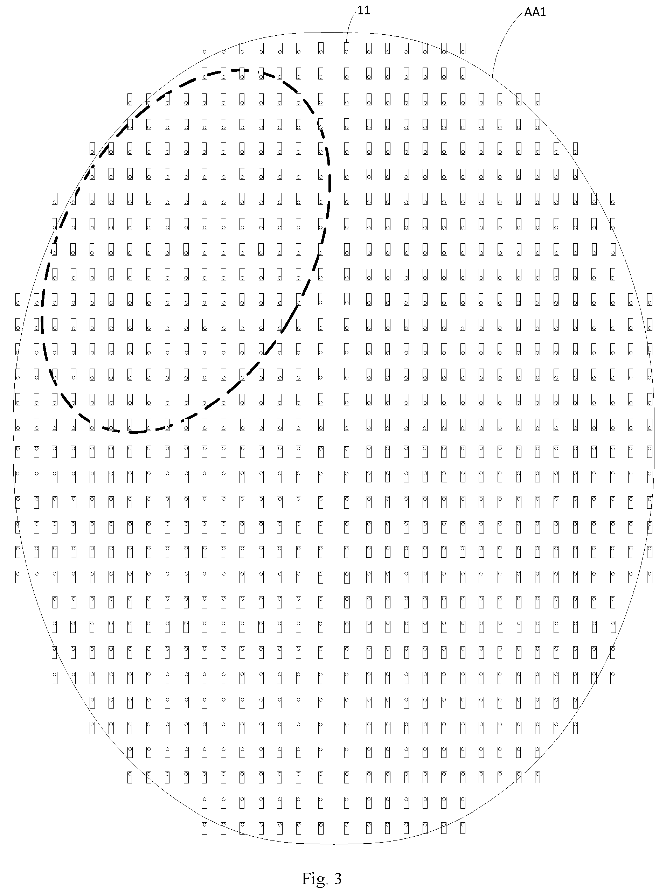

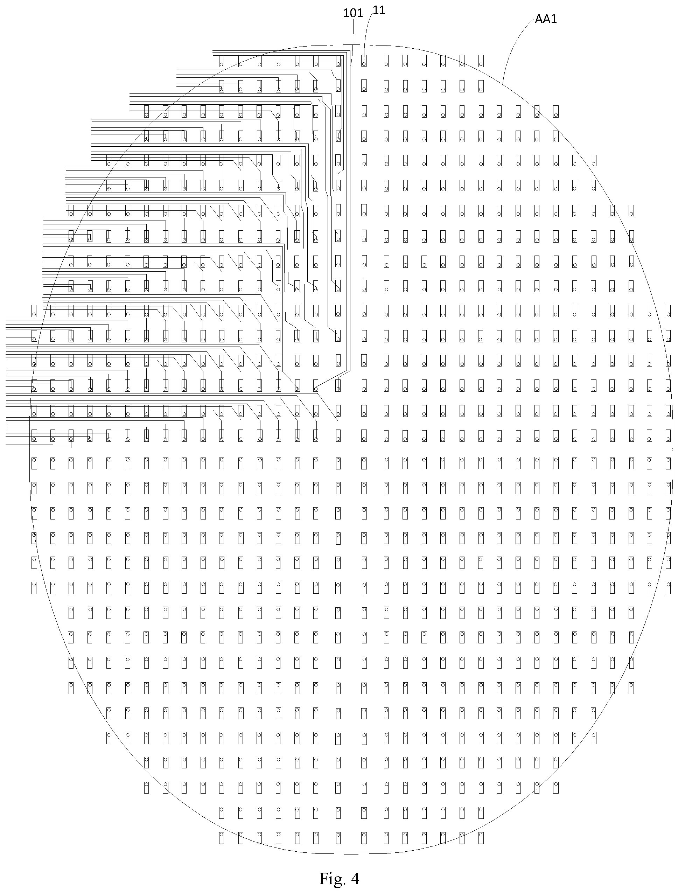

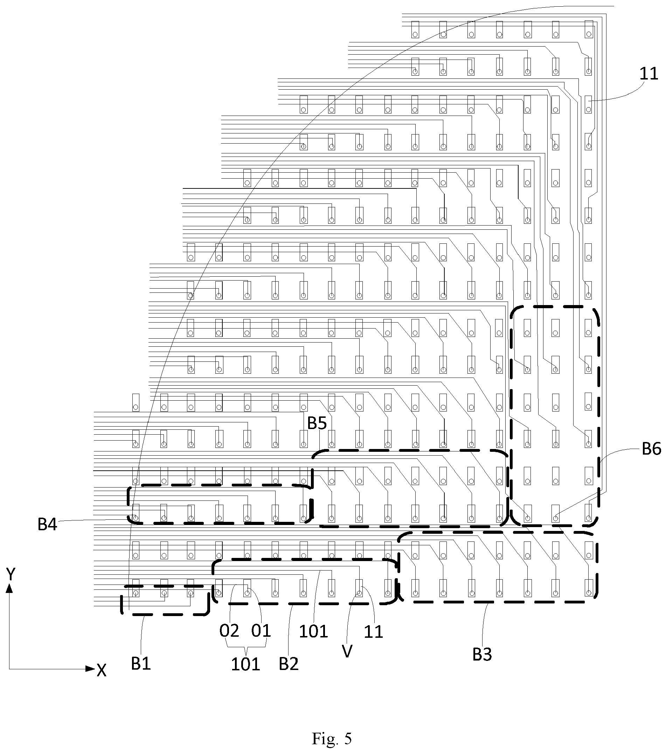

Aiming at the above technical problem existing in the related art, embodiments of the present disclosure provide a display substrate, as shown in Fig. 2 to Fig. 5. Fig. 2 is an integral schematic structural diagram of a display substrate. Fig. 3 is a schematic structural diagram of a first display region AA1 in Fig. 2. Fig. 4 illustrates a detailed schematic structural diagram of a quarter region where a dotted line box is located in Fig. 3. Fig. 5 is an enlarged schematic structural diagram of the quarter region where the dotted line box is located in Fig. 4.

The display substrate includes a base substrate 10. The base substrate has a display region AA and a frame region BB surrounding the display region AA. The display region AA includes a first display region AA1 and a second display region AA2 at least located on one side of the first display region AA1. Light transmittance of the first display region AA1 is greater than light transmittance of the second display region AA2.

The display substrate includes a drive circuit layer on the base substrate 10. The drive circuit layer includes a plurality of first pixel circuits D1 and a plurality of second pixel circuits D2. Orthographic projections of the first pixel circuits D1 on the base substrate 10 do not overlap an orthographic projection of the first display region AA1 on the base substrate 10. The second pixel circuits D2 are located in the second display region AA2. Fig. 1 merely illustrates part of the first pixel circuits D 1 and part of the second pixel circuits D2.

The display substrate includes a light-emitting device layer on one side of the drive circuit layer facing away from the base substrate 10. The light-emitting device layer includes a plurality of first light-emitting devices and a plurality of second light-emitting devices. The first light-emitting devices are located in the first display region AA1, and the second light-emitting devices are located in the second display region AA2. The first light-emitting devices each includes a first anode 11 independently arranged, and the second light-emitting devices each includes a second anode 12 independently arranged. The plurality of first anodes 11 each is electrically connected with a respective one of the plurality of first pixel circuits D 1. The plurality of second anodes 12 each is electrically connected with a respective one of the plurality of second pixel circuits D2. A density (i.e., the pixel resolution ratio) of the plurality of first light-emitting devices in the first display region AA1 is the same as a density of the plurality of second light-emitting devices in the second display region AA2.

The display substrate includes at least one transparent conducting layer between the drive circuit layer and the light-emitting device layer. Each layer of the at least one transparent conducting layer includes a plurality of first anode wires 101 electrically connected with the first anodes 11. The first anode wire 101 at least include a first portion 01 extending in a column direction Y and a second portion 02 extending in a row direction X. The second portions 02 of the plurality of first anode wires 101 electrically connected with the same row of first anodes 11 are located between two different adjacent rows of first anodes 11. The second portions 02 are led out in the row direction X to an outside of the first display region AA1.

In the above display substrate provided by the embodiments of the present disclosure, the second pixel circuits D2 and the corresponding second light-emitting devices are arranged in the second display region AA2. The first pixel circuits D1 corresponding to the first display region AA1 with high light transmittance are not arranged in the first display region AA1. The density (namely a pixel resolution ratio) of the plurality of first light-emitting devices in the first display region AA1 is the same as the density of the plurality of second light-emitting devices in the second display region AA2. Therefore, images with the same pixel resolution ratio can be displayed in an under-screen camera display region (namely the first display region AA1), and the light-emitting brightness of the under-screen camera display region can also be improved. A brightness difference between a main display region (namely the second display region AA2) and the under-screen camera display region (namely the first display region AA1) is reduced. Further, a diameter of a hole of the under-screen camera display region may be enlarged, so as to achieve a better full-screen display effect and improve the user experience.

It needs to be illustrated that the first anodes and the first anode wires are electrically connected through a via hole penetrating through an insulation layer between the first anodes and the first anode wires. A position between the two adjacent rows of first anodes does not strictly refer to a gap between the two adjacent rows of first anodes. Orthographic projections of the second portions of the first anode wires on the base substrate may overlap orthographic projections of the first anodes on the base substrate. Thus in embodiments of the present disclosure, a position between the two adjacent rows of first anodes refers to a gap between two adjacent rows of via holes where the two adjacent rows of first anodes are electrically connected with the corresponding transparent conducting layers. That is, a position between the two adjacent rows of first anodes refers to a position between two adjacent rows of via holes V in Fig. 5.

It needs to be illustrated that in the present disclosure, a shape of the first display region AA1 may be a circle shown in Fig. 2, and may also be an oval, a rectangle or a polygon and other shapes, which may be designed according to actual requirements and is not limited here. The second display region AA2 may surround a periphery of the first display region AA1 as shown in Fig. 2, and may also surround part of the first display region AA1, for example, surrounding a left side, a lower side and a right side of the first display region AA1, and an upper side boundary of the first display region AA1 coincides with an upper side boundary of the second display region AA2. In addition, in the present disclosure, the first light-emitting devices and the second light-emitting devices are light-emitting pixels actually used for displaying, and the first pixel circuits and the second pixel circuits are circuits used for connecting the light-emitting pixels.

Optionally, in order to improve the light transmittance of the first display region, in the above display substrate provided by the embodiments of the present disclosure, as shown in Fig. 2, the plurality of first pixel circuits D1 are located in the frame region BB adjacent to the first display region AA1. Fig. 2 illustrates that the plurality of first pixel circuits D1 are located in an upper frame region. In addition, the plurality of first pixel circuits D1 are arranged in the frame region BB jointly adjacent to the plurality of first light-emitting devices and the plurality of second light-emitting devices, a length of a transparent wire between the first pixel circuits D1 and the first light-emitting devices may be effectively reduced, then a resistance of the transparent wire is reduced, and the long range uniformity of drive signals is improved.

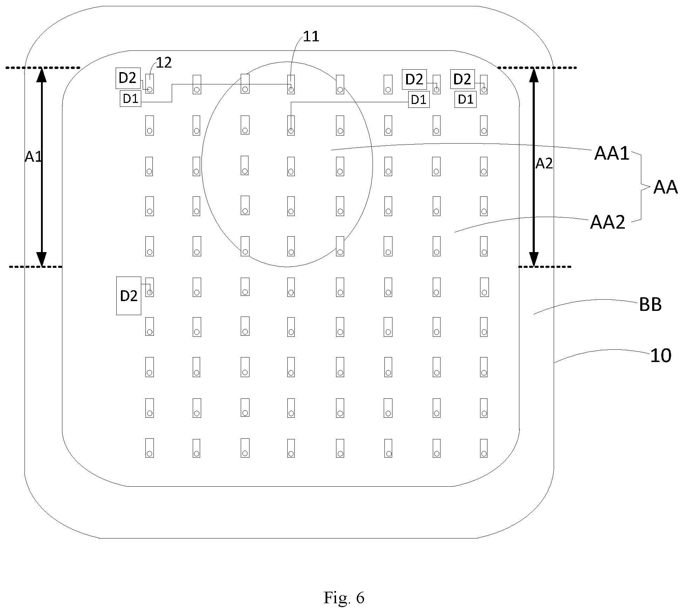

Optionally, in the above display substrate provided by the embodiments of the present disclosure, as shown in Fig. 6, the second display region AA2 has a seventh region A1 and an eighth region A2 which are adjacent to the first display region AA1. The seventh region A1 and the eighth region A2 are oppositely arranged. An area occupied by a second pixel circuit D2 in either the seventh region A1 or the eighth region A2 is smaller than an area occupied by a second pixel circuits D2 in other regions of the second display region AA2. A plurality of first pixel circuits D1 are located in the seventh region A1 and the eighth region A2. According to the present disclosure, by reducing the areas of the second pixel circuits D2 in the seventh region A1 and the eighth region A2, a plurality of first pixel circuits D1 corresponding to the first display region AA1 are arranged in the seventh region A1 and the eighth region A2. In this way, the under-screen camera display region (namely the first display region AA1) may display the images with the same pixel resolution ratio, the light-emitting brightness of the under-screen camera display region may be improved, and the brightness difference between the main display region (namely the second display region AA2) and the under-screen camera display region (namely the first display region AA1) is reduced.

It needs to be illustrated that in Fig. 6, each region merely illustrates part of pixel circuit structures.

Optionally, in the above display substrate provided by the embodiments of the present disclosure, as shown in Fig. 5, the at least one transparent conducting layer includes a first transparent conducting layer and a second transparent conducting layer which are stacked and insulated from each other.

In every two adjacent rows of first anodes 11, such as the last row and the second row from the bottom in Fig. 5, the first anode wires 101 corresponding to one row (such as the last row) of first anodes 11 are located on the first transparent conducting layer, and the first anode wires 101 corresponding to the other row (such as the second row from the bottom) of first anodes 11 are located on the second transparent conducting layer.

For example, it assumes that in Fig. 5, the first row, the second row, the third row... are sequentially arranged from the last row up, the first anode wires 101 corresponding to the odd row of first anodes 11 are located on the first transparent conducting layer, and the first anode wires 101 corresponding to the even row of first anodes 11 are located on the second transparent conducting layer.

It needs to be illustrated that in the embodiments of the present disclosure, Fig. 4 and Fig. 5 merely illustrate the first anode wires 101 corresponding to the odd row of first anodes 11. A wiring mode of the first anode wires 101 corresponding to the even row of first anodes 11 is the same as a wiring mode of the first anode wires 101 corresponding to the odd row of first anodes 11. A difference of the odd row and the even row is merely that cathode wires corresponding to the odd row and the even row are located on different conducting layers.

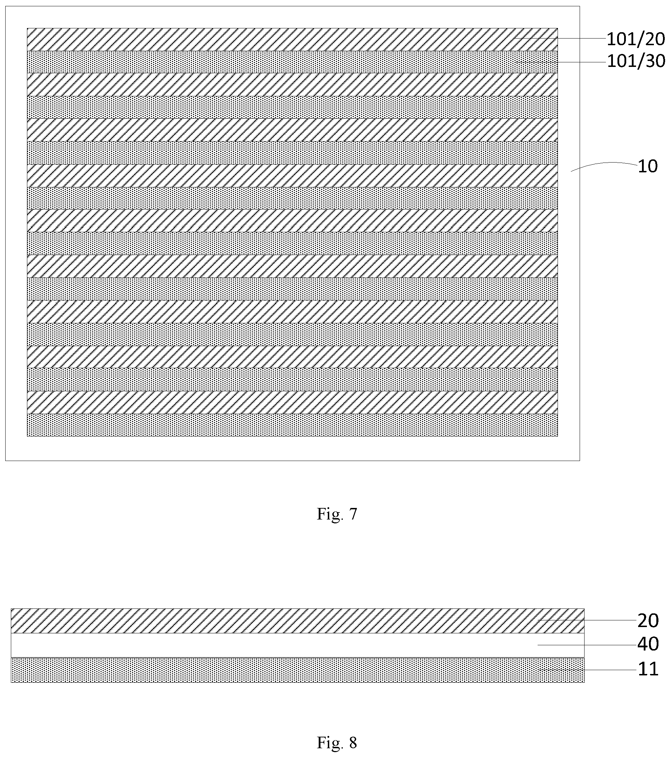

Optionally, in the above display substrate provided by the embodiments of the present disclosure, as shown in Fig. 7, Fig. 7 is a schematic top view of a first transparent conducting layer 20 and a second transparent conducting layer 30, the plurality of first anode wires contained in each transparent conducting layer do not overlap each other. For example, the plurality of first anode wires 101 contained in the first transparent conducting layer 20 do not overlap each other, and the plurality of first anode wires 101 contained in the second transparent conducting layer 30 do not overlap each other. Orthographic projections of the plurality of first anode wires contained in different transparent conducting layers on the base substrate are staggered with each other. For example, orthographic projections of the plurality of first anode wires 101 contained in the first transparent conducting layer 20 on the base substrate 10 and orthographic projections of the plurality of first anode wires 101 contained in the second transparent conducting layer 30 on the base substrate 10 are staggered with each other. That is, when two transparent conducting layers are adopted, the first transparent conducting layer 20 and the second transparent conducting layer 30 alternate on opposite gaps for wiring, overlapping between the two layers is reduced as much as possible, and thus loading among the first anode wires 101 is reduced.

Optionally, in the above display substrate provided by the embodiments of the present disclosure, as shown in Fig. 6 and Fig. 8, an insulation layer 40 is provided between the first anodes 11 and the transparent conducting layer (such as the first conducting layer 20). The insulation layer 40 is provided with a plurality of via holes V for electrically connecting the first anodes 11 with the first anode wires 101. The orthographic projections of the first anode wires 101 on the base substrate 10 and orthographic projections of the via holes V on the base substrate 10 do not overlap.

Optionally, in the above display substrate provided by the embodiments of the present disclosure, the first transparent conducting layer and the second transparent conducting layer have the same patterns. For example, when the odd row of first anode wires 101 in Fig. 5 are arranged on the first transparent conducting layer, the even row of first anode wires 101 in Fig. 5 are arranged on the second transparent conducting layer, Fig. 5 merely illustrates a wiring mode of the odd row of first anode wires 101. The wiring mode of the even row of first anode wires 101 is the same as the wiring mode of the odd row. A difference is that orthographic projections of the odd row of wires and the even row of wires are arranged in a staggered manner.

Optionally, in the above display substrate provided by the embodiments of the present disclosure, as shown in Fig. 5, the quantity of the first anode wires between two adjacent rows of first anodes 11 (such as the first anode wires 101 between the last row of first anodes 11 and the second row from bottom of the first anodes 11 in Fig. 5) corresponding to each transparent conducting layer is not greater than a first quantity. Since each transparent conducting layer is provided with anode wires, due to the requirements such as the pixel resolution ratio, the quantity of wires between two adjacent rows of first anodes 11 of each transparent conducting layer is generally 11-15. For example, the first quantity may be 13. In the present disclosure, taking two transparent conducting layers as an example, in an integral structure of the two transparent conducting layers, the total quantity of wires between two adjacent rows of first anodes 11 generally does not exceed 26. The quantity of the first anode wires between two adjacent columns of first anodes 11 (such as the first anode wires 101 between the first column of the first anodes 11 and the second column of first anodes 11 from the right in Fig. 5) corresponding to each transparent conducting layer is not greater than a second quantity. Since each transparent conducting layer is provided with the anode wires, at present, due to the requirements such as the pixel resolution ratio, the quantity of wires between two adjacent columns of first anodes 11 of each transparent conducting layer is generally 2-6. For example, the second quantity may be 4. In the present disclosure, taking two transparent conducting layers as an example, in an integral structure of the two transparent conducting layers, the total quantity of wires between two adjacent columns of first anodes 11 generally does not exceed 8. Thus, the first quantity is greater than the second quantity.

It needs to be illustrated that in order to clearly illustrate the wiring mode of the first anode wires 101 in the first display region AA1, in Fig. 5, taking the quantity of wires between two adjacent rows of first anodes being 7 as an example for illustration.

It needs to be illustrated that the first anodes and the first anode wires are electrically connected through the via holes penetrating through the insulation layer between the first anodes and the first anode wires. A position between the two adjacent columns of first anodes does not strictly refer to a gap between the two adjacent columns of first anodes. Orthographic projections of the first portions of the first anode wires on the base substrate may overlap orthographic projections of the first anodes on the base substrate. Thus in the embodiments of the present disclosure, a position between two adjacent columns of first anodes refers to a gap between two adjacent columns of via holes where the two adjacent columns of first anodes are electrically connected with the corresponding transparent conducting layers. That is, a position between two adjacent columns of first anodes refers to a position between two adjacent columns of via holes V in Fig. 5.

Optionally, in the above display substrate provided by the embodiments of the present disclosure, as shown in Fig. 5, at least one row of first anodes is divided into a first region, a second region and a third region which are adjacent. For example, in Fig. 5, the last row of first anodes is divided into a first region B 1, a second region B2 and a third region B3 which are adjacent. The first anode wires 101 corresponding to the first region B 1 are located in a gap between a same pair of two adjacent rows of first anodes 11 (between the last row and the mirror-symmetric first row in Fig. 5). The first anode wires 101 corresponding to the second region B2 are located in a gap between a same pair of two adjacent rows of first anodes 11 (between the last row and the second row from the bottom). The first anode wires 101 corresponding to the third region B3 are located in a gap between a same pair of two adjacent rows of first anodes 11 (between the second row from the bottom and the third row from the bottom). The first anode wires 101 corresponding to the first region B1, the second region B2 and the third region B3 respectively are located in gaps between different pairs of two adjacent rows of first anodes 11.

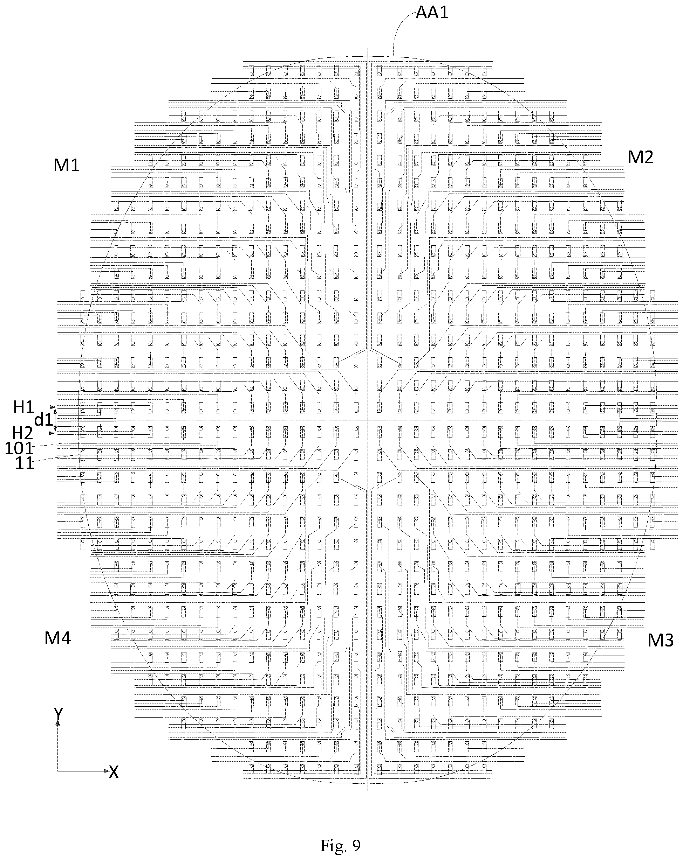

For example, as shown in Fig. 5 and Fig. 9, Fig. 9 is a complete wiring structure of anode wires of odd rows of pixels of the first display region AA1, and Fig. 5 is a schematic diagram of a quarter region of the upper left part in Fig. 9. The lower left part in Fig. 9 is further provided with another quarter region of the first display region AA1. The position between the last row of first anodes 11 in Fig. 5 and the first row of first anodes 11 in the another quarter region of the lower left part in Fig. 9 may serve as a wiring region for anode wires corresponding to the first regions B 1 in the two rows. Since 7 wires may be arranged between two adjacent rows of first anodes, and the wires are divided equally by the two rows, three first anode wires 101 corresponding to the left side of the last row in Fig. 5 and three first anode wires 101 corresponding to the left side of the first row in the another quarter region of the lower left part in Fig. 9 are respectively distributed between the last row of first anodes 11 in Fig. 5 and the first row of first anodes 11 in the another quarter region of the lower left part in Fig. 9. Taking an example that the quantity of the first anode wires 101 corresponding to either the second region B2 or the third region B3 is 7, 7 first anode wires 101 corresponding to the second region B2 are all arranged between the last row of first anodes 11 and the second row from the bottom of first anodes 11 in Fig. 5. The first anode wire 101 firstly extends in a column direction Y, then extends in a row direction X and is led out of the first display region AA1, and then is electrically connected with the first pixel circuit D1 in Fig. 2 or Fig. 6.

Optionally, in the above display substrate provided by the embodiments of the present disclosure, as shown in Fig. 2 and Fig. 5, the first region B 1 is close to the second display region AA2, the second region B2 is located on one side of the first region B 1 away from the second display region AA2, and the third region B3 is located on one side of the second region B2 away from the second display region AA2.

The quantity of the first anode wires 101 corresponding to the first region B1 is not greater than half of the first quantity (for example, the first quantity is 7, the quantity of the first anode wires 101 of the first region B1 in Fig. 5 is 3), and the quantity of the first anode wires 101 corresponding to either the second region B2 or the third region B3 is the first quantity (for example, the quantities of the first anode wires 101 corresponding to the second region B2 and the third region B3 are both 7).

Optionally, in the above display substrate provided by the embodiments of the present disclosure, as shown in Fig. 5, at least one row of first anodes is divided into a fourth region, a fifth region and a sixth region which are adjacent. For example, in Fig. 5, the third row from the bottom of first anodes is divided into a fourth region B4, a fifth region B5 and a sixth region B6 which are adjacent. The first anode wires 101 corresponding to the fourth region B4 are located in a gap between a same pair of two adjacent rows of first anodes 11 (between the third row from the bottom and the fourth row from the bottom). The first anode wires 101 corresponding to the fifth region B5 are located in a gap between a same pair of two adjacent rows of first anodes 11 (between the fourth row from the bottom and the fifth row from the bottom). The first anode wires 101 corresponding to the sixth region B6 are located in a gap between different pairs of two adjacent rows of first anodes 11. The first anode wires 101 corresponding to the fourth region B4, the fifth region B5 and the sixth region 6 are respectively located in gaps between different pairs of two adjacent rows of first anodes 11.

For example, as shown in Fig. 5, since the fourth region B4, the fifth region B5 and the sixth region 6 are in the third row from the bottom of pixels. The first anode wires 101 corresponding to the three regions are only arranged between two adjacent rows of first anodes 11 on the upper side. The quantities of wires of the fourth region B4 and the fifth region B5 are both 7, then 7 first anode wires 101 corresponding to the fourth region B4 are arranged between the third row from the bottom and the fourth row from the bottom, and 7 first anode wires 101 corresponding to the fifth region B5 are arranged between the fourth row from the bottom and the fifth row from the bottom. Three first anode wires 101 corresponding to the sixth region B6 in the third row from the bottom of pixels firstly extend in the column direction, and then are led out to the second display region AA2 in the row direction between two adjacent rows of first anodes 11 having less than 7 wires.

Optionally, in the above display substrate provided by the embodiments of the present disclosure, as shown in Fig. 2 and Fig. 5, the fourth region B4 is close to the second display region AA2, the fifth region B5 is located on one side of the fourth region B4 away from the second display region AA2, and the sixth region B6 is located on one side of the fifth region B5 away from the second display region AA2.

The quantity of the first anode wires 101 corresponding to the fourth region B4 is the first quantity (for example, the quantity of the first anode wires 101 corresponding to the fourth region B4 is 7). The quantity of the first anode wires 101 corresponding to the fifth region B5 is the first quantity (for example, the quantity of the first anode wires 101 corresponding to the fifth region B5 is 7). The quantity of the first anode wires 101 corresponding to the sixth region B6 is not greater than half of the first quantity (for example, the quantity of the first anode wires 101 corresponding to the sixth region B6 is smaller than or equal to 3).

The layout mode of the first anode wires 101 in the upper left part of the first display region AA1 shown in Fig. 4 is described in detailed. As shown in Fig. 5, in odd rows of pixels (the first row from the bottom, the third row from bottom, the fifth row from the bottom, the seventh row from the bottom, the ninth row from bottom, the eleventh row from the bottom, the thirteenth row from the bottom and the fifteenth row from bottom), the first row from the bottom is divided into three regions of B 1, B2 and B3. B2 and B3 both correspond 7 first anode wires 101. The first anode wires 101 corresponding to the region B2 extend in the column direction to be between the first row from the bottom of first anodes 11 and the second row from the bottom of first anodes 11, and then extend in the row direction to lead out to the second display region AA2. Three first anode wires 101 corresponding to B1 firstly extend downwards, and then extend to the left to lead out to the second display region AA2.

In the third row from the bottom, 7 first anode wires 101 corresponding to the first anodes 11 on the left side are arranged between the third row from the bottom of the first anodes 11 and the fourth row from the bottom of the first anodes 11. 7 first anode wires 101 corresponding to the eighth to the fourteenth first anodes 11 on the left side are arranged between the fourth row from the bottom of the first anodes 11 and the fifth row from the bottom of the first anodes 11. 3 first anodes 11 further remain to the right side of the third row from the bottom.

In the fifth row from the bottom, 7 first anode wires 101 corresponding to the first anodes 11 on the left side are arranged between the fifth row from the bottom of the first anodes 11 and the sixth row from the bottom of the first anodes 11. 7 first anode wires 101 corresponding to the eighth to the fourteenth first anodes 11 on the left side are arranged between the sixth row from the bottom of the first anodes 11 and the seventh row from the bottom of the first anodes 11. 3 first anodes 11 further remain to the right side of the fifth row from the bottom.

In the seventh row from the bottom, 7 first anode wires 101 corresponding to the first anodes 11 on the left side are arranged between the seventh row from the bottom of the first anodes 11 and the eighth row from the bottom of the first anodes 11. 5 first anode wires 101 corresponding to the eighth to the twelfth first anodes 11 on the left side are arranged between the eighth row from the bottom of the first anodes 11 and the ninth row from the bottom of the first anodes 11. Since only 5 first anode wires 101 are arranged between the eighth row from the bottom of the first anodes 11 and the ninth row from the bottom of the first anodes 11, the first anode wire 101 corresponding to the first anode on the left side in three first anodes 11 on the right side of the third row from the bottom of the first anodes 11 and the first anode on the left side in three first anodes 11 on the right side of the fifth row from the bottom of the first anodes 11 may go upwards to be between the eighth row from the bottom of the first anodes 11 and the ninth row from the bottom of the first anodes 11, and then may be led out in the row direction.

In the ninth row from the bottom, 7 first anode wires 101 corresponding to the first anodes 11 on the left side are arranged between the ninth row from the bottom of the first anodes 11 and the tenth row from the bottom of the first anodes 11. 6 first anode wires 101 corresponding to the eighth to the thirteenth first anodes 11 on the left side are arranged between the tenth row from the bottom of the first anodes 11 and the eleventh row from the bottom of the first anodes 11. Since only 6 first anode wires 101 are arranged between the tenth row from the bottom of the first anodes 11 and the eleventh row from the bottom of the first anodes 11, the first anode wire 101 corresponding to the first anode on the left side in three first anodes 11 on the right side of the seventh row from the bottom of the first anodes 11 may go upwards to be between the tenth row from the bottom of the first anodes 11 and the eleventh row from the bottom of the first anodes 11, and then may be led out in the row direction.

In the eleventh row from the bottom, 7 first anode wires 101 corresponding to the first anodes 11 on the left side are arranged between the eleventh row from the bottom of the first anodes 11 and the twelfth row from the bottom of the first anodes 11. 4 first anode wires 101 corresponding to the eighth to the eleventh first anodes 11 on the left side are arranged between the twelfth row from the bottom of the first anodes 11 and the thirteenth row from the bottom of the first anodes 11. Since only 4 first anode wires 101 are arranged between the twelfth row from the bottom of the first anodes 11 and the thirteenth row from the bottom of the first anodes 11, the first anode wire 101 corresponding to the first anode in the middle in three first anodes 11 on the right side of the fifth row from the bottom of the first anodes 11, the first anode wire 101 corresponding to the first anode in the middle in three first anodes 11 on the right side of the seventh row from the bottom, and the first anode wire 101 corresponding to the first anode in the middle in three first anodes 11 on the right side of the ninth row from the bottom of the first anodes 11 may go upwards to be between the twelfth row from the bottom of the first anodes 11 and the thirteenth row from the bottom of the first anodes 11, and then may be led out in the row direction.

In the thirteenth row from the bottom, 7 first anode wires 101 corresponding to the first anodes 11 on the left side are arranged between the thirteenth row from the bottom of the first anodes 11 and the fourteenth row from the bottom of the first anodes 11. 3 first anode wires 101 corresponding to the eighth to the tenth first anodes 11 on the left side are arranged between the fourteenth row from the bottom of the first anodes 11 and the fifteenth row from the bottom of the first anodes 11. Since only 3 first anode wires 101 are arranged between the fourteenth row from the bottom of the first anodes 11 and the fifteenth row from the bottom of the first anodes 11, the first anode wire 101 corresponding to the first anode in the middle in three first anodes 11 on the right side of the eleventh row from the bottom of the first anodes 11 may go upwards to be between the fourteenth row from the bottom of the first anodes 11 and the fifteenth row from the bottom of the first anodes 11, and then may be led out in the row direction. The first anode wire 101 corresponding to the first anode on the farthest right side in three first anodes 11 on the right side of the fifth row from the bottom of the first anodes 11, the first anode wire 101 corresponding to the first anode on the farthest right side in three first anodes 11 on the right side of the seventh row from the bottom, and the first anode wire 101 corresponding to the first anode on the farthest right side in three first anodes 11 on the right side of the ninth row from the bottom of the first anodes 11 may go upwards to be between the fourteenth row from the bottom of the first anodes 11 and the fifteenth row from the bottom of the first anodes 11, and then may be led out in the row direction.

In the fifteenth row from the bottom, 7 first anode wires 101 corresponding to the first anodes 11 are arranged between the fifteenth row from the bottom of the first anodes 11 and the sixteenth row from the bottom of the first anodes 11. The first anode wire 101 corresponding to the first anode on the farthest right in three first anodes 11 on the right side of the eleventh row from the bottom, and the first anode wire 101 corresponding to the first anode on the farthest right in three first anodes 11 on the right side of the thirteenth row from the bottom of the first anodes 11 may go upwards to be on the upper side of the sixteenth row from the bottom of the first anodes 11, and then may be led out in the row direction. Two first anode wires 101 corresponding to the first anodes 11 in the middle and on the farthest right in three first anodes 11 on the right side of the third row from the bottom of the first anodes 11 may go upwards to be on the upper side of the sixteenth row from the bottom of the first anodes 11, and then may led out in the row direction.

It needs to be illustrated that Fig. 5 takes an example that at most 7 first anode wires 101 are accommodated between two adjacent rows of first anodes for illustration. During practical applications, wiring is performed according to the wiring mode of the present disclosure according to the practical condition.

Optionally, in the above display substrate provided by the embodiments of the present disclosure, as shown in Fig. 9, the first display region AA1 is divided by center lines in the row direction X and the column direction Y into four equal parts (M1, M2, M3 and M4). The first anode wire of each equal part adopts the layout mode of the first anode wire 101 in the display substrate shown in Fig. 5.

Optionally, in the above display substrate provided by the embodiments of the present disclosure, as shown in Fig. 9, the four equal parts include a first equal part M1, a second equal part M2, a third equal part M3 and a fourth equal part M4 which are clockwise arranged. The first equal part M1 and the second equal part M2 are symmetrically arranged with respect to the center line in the column direction Y The second equal part M2 and the third equal part M3 are symmetrically arranged with respect to the center line in the row direction X. The third equal part M3 and the fourth equal part M4 are symmetrically arranged with respect to the center line in the column direction Y The fourth equal part M4 and the first equal part M1 are symmetrically arranged with respect to the center line of the row direction X.

Optionally, in the above display substrate provided by the embodiments of the present disclosure, as shown in Fig. 9, the row of first anodes closest to the fourth equal part M4 in the first equal part M1 is a first row of first anodes H1. The row of first anodes closest to the first equal part M1 in the fourth equal part M4 is a second row of first anodes H2. A first gap d1 is located between the first row of first anodes H1 and the second row of first anodes H2. The first anode wires 101 corresponding to the first region B1 close to the second display region AA2 in the first row of first anodes H1 and the first anode wires 101 corresponding to the first region B1 close to the second display region AA2 in the second row of first anodes H2 are located in the first gap.

It needs to be illustrated that there are two transparent conducting layers in embodiments of the present disclosure. In order to clearly illustrate a layout mode of anode wires in each transparent conducting layer, Fig. 5 and Fig. 9 only illustrate the layout mode of the odd row of first anode wires corresponding to one of the transparent conducting layers. The layout mode of the even row of first anode wires corresponding to the other one of the transparent conducting layers is the same as the layout mode of the odd row, but orthographic projections of the two layers of wires are arranged in a staggered manner.

Further, during implementations, there may be only one transparent conducting layer, then each row of first anodes in the first display region electrically connects to the second pixel circuits by using the first anode wires arranged in the same transparent conducting layer. There may be three transparent conducting layers, then the first row, the fourth row, the seventh row... and the like of first anode wires are arranged on the first transparent conducting layer, the second row, the fifth row, the eighth row... and the like of first anode wires are arranged on the second transparent conducting layer, and the third row, the sixth row, the ninth row... and the like of first anode wires are arranged on the third transparent conducting layer. Similar arrangement can be done for the other quantity of transparent conducting layers.

Optionally, in the above display substrate provided by the embodiments of the present disclosure, a material of the transparent conducting layer may be ITO.

Optionally, in the above display substrate provided by the embodiments of the present disclosure, as shown in Fig. 2, the first display region AA1 is configured to install a photosensitive device, such as a camera module.

Since in the present disclosure, only the first light-emitting device exists in the first display region AA1, a transmitting region with a larger area can be provided, which is conductive to adapting to a camera module with a larger size.

In another aspect, embodiments of the present disclosure further provide a display panel, including the above display substrate.

In yet another aspect, embodiments of the present disclosure further provide a display apparatus, including: a photosensitive device (such as a camera module), and the above display panel. The photosensitive device is arranged in a first display region AA1 of a display substrate. Optionally, the photosensitive device may be the camera module.

The display apparatus may be a mobile phone, a tablet computer, a television, a display, a notebook computer, a digital photo frame, a navigator, a smart watch, a fitness wristband, a personnel digital assistant and any products or components with display functions. Other essential constituent parts of the display apparatus should be understood by those of ordinary skill in the art, which is not repeated here, and should not limit the present disclosure. In addition, the principle of the display apparatus solving the problem is similar to the principle of the above display panel solving the problem, therefore, the implementations of the display apparatus may refer to the embodiments of the above display panel, and repetitions are omitted.

According to the display substrate, the display panel and the display apparatus provided by the embodiments of the present disclosure, second pixel circuits and corresponding second light-emitting devices are arranged in a second display region. First pixel circuits corresponding to a first display region with a high light transmittance are not arranged in the first display region. The density (namely pixel resolution ratio) of the plurality of first light-emitting devices in the first display region is the same as the density of the plurality of second light-emitting devices in the second display region. Therefore an under-screen camera display region (namely the first display region) may display images with the same pixel resolution ratio, and the light-emitting brightness of the under-screen camera display region is also improved. A brightness difference between a main display region (namely the second display region) and the under-screen camera display region (namely the first display region) is reduced. Further a diameter of a hole of the under-screen camera display region may be enlarged, so as to achieve a better full-screen display effect and improve the user experience.

Although preferred embodiments have been described in the present disclosure, those skilled in the art may make additional variations and modifications to the embodiments of the present disclosure once known the basic creative concept. Therefore, the attached claims are intended to include the preferred embodiments and all variations and modifications falling within the scope of the present disclosure.

Apparently, those skilled in the art may make various changes and variations to the embodiments of the present disclosure without departing from the spirit and scope of the present disclosure. In this case, if these changes and variations of the present disclosure fall within the scope of the claims of the present disclosure and their equivalents, the present disclosure also intends to contain these changes and variations.

## Claims

1. A display substrate, comprising:
a base substrate comprising:
a display region comprising:
a first display region; and
a second display region at least on one side of the first display region; and
a frame region surrounding the display region;
wherein light transmittance of the first display region is greater than light transmittance of the second display region;
a drive circuit layer, located on the base substrate and comprising:
a plurality of first pixel circuits; and
a plurality of second pixel circuits;
wherein orthographic projections of the plurality of first pixel circuits on the base substrate do not overlap an orthographic projection of the first display region on the base substrate, and the plurality of second pixel circuits are in the second display region;
a light-emitting device layer, located on one side of the drive circuit layer facing away from the base substrate and comprising:
a plurality of first light-emitting devices in the first display region; and
a plurality of second light-emitting devices in the second display region;
wherein:
the plurality of first light-emitting devices comprises:
a plurality of first anodes independently arranged;
the plurality of second light-emitting device comprises:
a plurality of second anodes independently arranged;
wherein the plurality of first anodes each is electrically connected with a respective one of the plurality of first pixel circuits, and the plurality of second anodes each is electrically connected with a respective one of the plurality of second pixel circuits; and
a density of the plurality of first light-emitting devices in the first display region is same as a density of the plurality of second light-emitting devices in the second display region; and
at least one transparent conducting layer between the drive circuit layer and the light-emitting device layer;
wherein each layer of the at least one transparent conducting layer comprises:
a plurality of first anode wires electrically connected with the first anodes;
wherein the first anode wire at least comprises:
a first portion extending in a column direction; and
a second portion extending in a row direction;
wherein the second portions of the first anode wires electrically connected with one same row of first anodes are located between different pairs of two adjacent rows of first anodes, and the second portions are led out in the row direction to an outside of the first display region.

2. The display substrate according to claim 1, wherein:
the at least one transparent conducting layer comprises:
a first transparent conducting layer and a second transparent conducting layer which are stacked and insulated from each other;
wherein in every two adjacent rows of first anodes, the first anode wires corresponding to one of the two adjacent rows of first anodes are on the first transparent conducting layer, and the first anode wires corresponding to another one of the two adjacent rows of first anodes are on the second transparent conducting layer.

3. The display substrate according to claim 2, wherein the first transparent conducting layer and the second transparent conducting layer have same patterns.

4. The display substrate according to claim 1, wherein a quantity of the first anode wires between two adjacent rows of first anodes on each transparent conducting layer is not greater than a first quantity, a quantity of the first anode wires between two adjacent columns of first anodes on each transparent conducting layer is not greater than a second quantity, and the first quantity is greater than the second quantity.

5. The display substrate according to claim 4, wherein:
at least one row of first anodes is divided into:
a first region, a second region and a third region which are adjacent;
wherein the first anode wires corresponding to the first region are between a same pair of two adjacent rows of the first anodes;
the first anode wires corresponding to the second region are between a same pair of two adjacent rows of the first anodes;
the first anode wires corresponding to the third region are between a same pair of two adjacent rows of the first anodes; and
the first anode wires corresponding to the first region, the second region and the third region are between different pairs of two adjacent rows of first anodes.

6. The display substrate according to claim 5, wherein the first region is close to the second display region, the second region is on one side of the first region away from the second display region, and the third region is on one side of the second region away from the second display region; and
a quantity of the first anode wires corresponding to the first region is not greater than half of the first quantity, and quantities of the first anode wires corresponding to the second region and the third region are both the first quantity.

7. The display substrate according to claim 4, wherein:
at least one row of first anodes is divided into:
a fourth region, a fifth region and a sixth region which are adjacent,
wherein the first anode wires corresponding to the fourth region are between a same pair of two adjacent rows of first anodes;
the first anode wires corresponding to the fifth region are between a same pair of two adjacent rows of first anodes;
the first anode wires corresponding to the sixth region are between different pairs of two adjacent rows of first anodes; and
the first anode wires corresponding to the fourth region, the fifth region and the sixth region are located between different pairs of two adjacent rows of first anodes.

8. The display substrate according to claim 7, wherein the fourth region is close to the second display region, the fifth region is on one side of the fourth region away from the second display region, and the sixth region is on one side of the fifth region away from the second display region; and
a quantity of the first anode wires corresponding to the fourth region is the first quantity, a quantity of the first anode wires corresponding to the fifth region is the first quantity, and a quantity of the first anode wires corresponding to the sixth region is not greater than half of the first quantity.

9. The display substrate according to claim 4, wherein the first quantity is 11-15, and the second quantity is 2-6.

10. The display substrate according to claim 1, wherein:
the first anode wires on each transparent conducting layer do not overlap one another, and;
orthographic projections, on the base substrate, of the first anode wires on different transparent conducting layers are staggered with each other.

11. The display substrate according to claim 1, wherein an insulation layer is provided between the plurality of first anodes and the at least one transparent conducting layer, the insulation layer is provided with a plurality of via holes for electrically connecting the plurality of first anodes with the plurality of first anode wires, and orthographic projections of the plurality of first anode wires on the base substrate do not overlap orthographic projections of the plurality of via holes on the base substrate.

12. The display substrate according to claim 1, wherein the plurality of first pixel circuits are in the frame region adjacent to the first display region.

13. The display substrate according to claim 1, wherein the second display region comprises:
a seventh region and an eighth region which are adjacent to the first display region;
wherein the seventh region and the eighth region are oppositely arranged, an area occupied by a second pixel circuit in the seventh region or the eighth region is smaller than an area occupied by a second pixel circuit in other region of the second display region, and the plurality of first pixel circuits are in the seventh region and the eighth region.

14. The display substrate according to claim 1, wherein a shape of the first display region is a circle, an oval, a rectangle or a polygon.

15. The display substrate according to claim 14, wherein the first display region is divided into four equal parts along center lines of the row direction and the column direction, and a layout mode of the first anode wires of each equal part adopt a layout mode of the first anode wires in the display substrate according to any one of claims 1-13.

16. The display substrate according to claim 15, wherein the four equal parts comprise:
a first equal part, a second equal part, a third equal part and a fourth equal part which are clockwise arranged;
wherein the first equal part and the second equal part are symmetrically arranged with respect to a center line of the column direction, the second equal part and the third equal part are symmetrically arranged with respect to a center line of the row direction, the third equal part and the fourth equal part are symmetrically arranged with respect to the center line of the column direction, and the fourth equal part and the first equal part are symmetrically arranged with respect to the center line of the row direction.

17. The display substrate according to claim 16, wherein:
one row of first anodes closest to the fourth equal part in the first equal part is a first row of first anodes;
one row of first anodes closest to the first equal part in the fourth equal part is a second row of first anodes;
a first gap is between the first row of first anodes and the second row of first anodes; and
the first anode wires corresponding to the first region, close to the second display region, of the first row of first anodes and the first anode wires corresponding to the first region, close to the second display region, of the second row of first anodes are located in the first gap.

18. A display panel, comprising the display substrate according to any one of claims 1-17.

19. A display apparatus, comprising:
a photosensitive device, and
the display panel according to claim 18,
wherein the photosensitive device is arranged in the first display region of the display substrate.
